# EUROPÄISCHE PATENTSCHRIFT

(11) **EP 0 685 297 B1**
(45) Veröffentlichungstag und Bekanntmachung des Hinweises auf die Patenterteilung: **22.03.2000**
(21) Anmeldenummer: 95250130.2
(22) Anmeldetag: 30.05.1995
(51) Int. Cl.: B23Q 17/09, C23C 14/22, C23C 14/34

(54) **Werkzeug für Umform- und Zerspanungsvorrichtungen und Verfahren zum Herstellen eines beschichteten Werkzeugs**
Tool for forming and cutting apparatuses and method of making a coated tool
Outil pour des appareils de formage et de coupage et procédé de fabrication un outil revêtu

(30) Priorität: 30.05.1994 DE 4419393
(43) Veröffentlichungstag der Anmeldung: 06.12.1995
(73) Patentinhaber: FRAUNHOFER-GESELLSCHAFT ZUR FÖRDERUNG DER ANGEWANDTEN FORSCHUNG E.V., 80636 München (DE)
(72) Erfinder: Zamel, Stefan, D-52146 Würselen (DE); Lüthje, Holger, D-25469 Halstenbek (DE); Ketteler, Georg, D-52062 Aachen (DE); Dimigen, Heinz, Prof. Dr., D-522605 Hamburg (DE)
(74) Vertreter: Pfenning, Meinig & Partner

(56) Entgegenhaltungen:
- EP-A- 0 596 619
- WO-A-87/04236
- WO-A-87/04471
- WO-A-90/05607
- GB-A- 2 190 925
- PATENT ABSTRACTS OF JAPAN vol. 4 no. 14 (E-169) ,31.Januar 1980 & JP-A-54 154373 (HITACHI)

## Beschreibung

Die Erfindung betrifft ein Werkzeug für umformende und zerspanende Techniken, eine Vorrichtung zur Regelung von Umform- und Zerspanungsprozessen, sowie ein Verfahren zur Herstellung eines solchen Werkzeugs.

Aus der US 5 176 053 ist ein Schneidwerkzeug bekannt, das an seiner Freifläche Temperatursensoren und elektrische Leitungen in unterschiedlichen Abständen von der Schneidkante aufweist, die derart angeordnet sind, daß die Temperaturverteilung in dem Werkzeug in der Nähe der Schneidkante bestimmt werden kann. Mindestens einige der Temperatursensoren sind so angeordnet, daß sie im Laufe des Gebrauchs zerstört werden, wodurch der Verschleiß feststellbar ist.

Bei einem derartigen bekannten Schneidwerkzeug ist es nicht möglich, die Sensoren direkt auf der oder an der Schneidkante bzw. Spanfläche aufzubringen, da die Anordnung nicht in der Lage ist, den hohen Kräften im Bereich der unmittelbaren Verschleißfläche zu widerstehen.

Die WO-A-87/04236 offenbart ein Werkzeug nach dem Oberbegriff des Patentanspruchs 1. Sie beschreibt eine als Wendeschneidplatte ausgebildete mechanische Komponente mit darauf angebrachten Schaltkreisen, die eine sensorische Messung von Druck, Temperatur und Verschleiß der mechanischen Komponente ermöglichen sollen. Der Schichtaufbau erfolgt dabei mit Methoden der Schaltungs- und Halbleitertechnik unter Verwendung von Aufdampf- und Sputterverfahren, die eine atomare Aufbringung des Beschichtungsmaterials gestatten.

Der Erfindung liegt daher die Aufgabe zugrunde, ein Werkzeug für Umform- und Zerspanungsvorrichtungen zu schaffen, das die Möglichkeit der Messung von wichtigen Prozeßkenngrößen über Sensoren direkt an der Verschleißfläche, d.h. auf der Werkzeugoberfläche bzw. der Schneide zur Verfügung stellt, dessen Haltbarkeit und Standzeit jedoch nicht nachteilig beeinflußt wird und wobei die Sensoranordnung starken Kräften widerstehen soll.

Diese Aufgabe wird erfindungsgemäß durch die Merkmale des Patentanspruchs 1 gelöst.

Dadurch, daß Sensoren zur Messung von Temperatur und/oder des Verschleißes in Dünnschichttechnik mit der Funktionsschicht/Verschleißschutzschicht des Werkzeugs zu einer beschichtungstechnologisch integrierten und gradierten Schichtfolge vereinigt werden, können bei umformenden und zerspanenden Werkzeugen die wesentlichen Prozeßgrößen (Temperatur, Verschleiß und Kraft) direkt an der Werkzeugschneide gewonnen und zur Regelung der Umform- oder Zerspanungsprozesse verwandt werden. Aufgrund des Ionenätzens und gesteuerten Ionenbeschuß des Substrats und der aufwachsenden Schichten wird ein geschlossener Schichtaufbau mit schichttechnologischer Verbindung der Zwischenschichten und somit starker Haftung der Schichten untereinander erreicht. Es lassen sich intelligente Systeme schaffen, indem eine Regelung von Prozeßparametern, wie Schnittgeschwindigkeit oder Vorschub mittels wissensbasierter Rechnersysteme unter Zuhilfenahme beispielsweise von Fuzzy-Logik-Modulen durchgeführt wird. Der Schichtaufbau gewährleistet eine lange Lebensdauer und ist so ausgebildet, daß die Sensoren auf der bzw. an der direkten Verschleißfläche angebracht werden können, wobei auch gekrümmte Flächen möglich sind.

Das Aufbringen des Schichtaufbaus beispielsweise auf der Spanfläche ermöglicht eine Vereinfachung des Herstellungsverfahrens, da der Aufbau für alle Schneidflächen gleichzeitig durchgeführt werden kann und eine Vielzahl von Werkzeugen z.B. Wendeschneidplatten gleichzeitig bearbeitet werden können.

Durch die in den Unteransprüchen angegebenen Maßnahmen sind vorteilhafte Weiterbildungen und Verbesserungen möglich. Anspruch 10 definiert eine Vorrichtung zur Regelung von Umform- und Zerspanungsprozessen unter Verwendung eines erfindungsgemäßen Werkzeugs. Die Ansprüche 11 bis 19 betreffen Verfahren zur Herstellung eines derartigen Werkzeugs.

Ausführungsbeispiele der Erfindung sind in der Zeichnung dargestellt und werden in der nachfolgenden Beschreibung näher erläutert. Es zeigen:
- Fig. 1: eine schematische Darstellung eines als Drehmeißel ausgebildeten Werkzeugs entsprechend der vorliegenden Erfindung,
- Fig. 2: eine Aufsicht auf ein als Wendeschneidplatte ausgebildetes Werkzeug mit Temperatur- und Verschleißsensoren nach der vorliegenden Erfindung,
- Fig. 3a bis 3c: Schnittdarstellungen des Schichtaufbaus der Wendeplatte nach Fig. 2, und
- Fig. 4: ein anderes Ausführungsbeispiel einer Wendeplatte mit Multifunktionssensor.

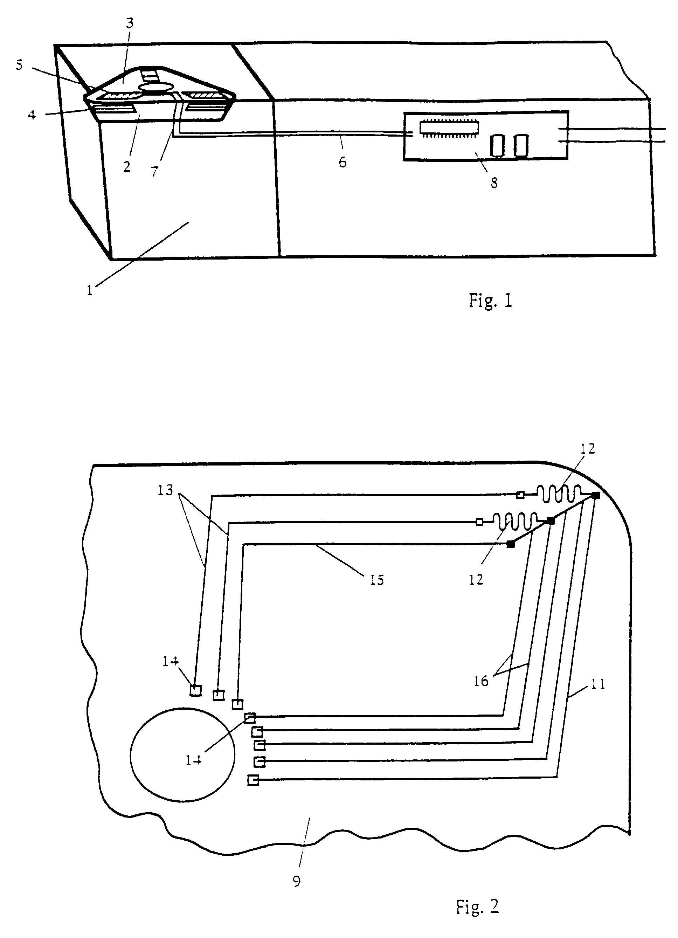

In Fig. 1 ist ein Drehmeißel 1 dargestellt, der einen mit der Schneidkante versehene Schneidplatte 2 aufweist. Schematisch ist an der Schneidplatte 2 ein Sensor 3 dargestellt, der in Dünnschichttechnik als Zwischenschicht aufgebracht ist und unter einer Verschleißschutzschicht, wie später näher beschrieben wird, liegt. Während der Zerspanvorgangs mit einem solchen Werkzeug treten an der Schneidplatte 2 bzw. an ihrer Schneidkante Verschleißerscheinungen auf, die sich je nach Belastungsart und -dauer unterschiedlich stark ausbilden. Die Schneidplatte verschleißt auf der Freifläche 4 (Freiflächenverschleiß) und auf der Spanfläche 5 (Kolkverschleiß). Daher werden vorzugsweise in diesem Bereich, wie angedeutet, Sensoren entsprechend Sensor 3 vorgesehen. Der Sensor 3 ist mit Leiterbahnen 6 verbunden, die an den jeweiligen Übergängen Kontaktierungen 7 aufweisen und mit einer Schaltung 8 verbunden sind. Diese Schaltung dient der Vorverarbeitung bzw. der Auswertung der Sensorsignale und ist in der Nähe des Sensors 3 an dem Werkzeug 1 bzw. dessen Halterung angebracht. Vorzugsweise ist die Schaltung 8 als Mikroschaltung ausgebildet. Die Schaltung 8 ist über Verbindungsleitungen mit einer Steuer- und Regelschaltung verbunden, die abhängig von den Sensorsignalen die jeweiligen Parameter der das Werkzeug 1 aufweisenden Maschine steuert bzw. regelt, wobei diese Parameter beispielsweise die Schneidgeschwindigkeit oder der Vorschub oder dergleichen sein können. Die Signale zwischen der Signalvorverarbeitungs-/Auswerteschaltung und der Steuer- und Regelschaltung können auch telemetrisch übertragen werden.

In Fig. 2 ist eine Teilansicht an der Wendeschneidplatte 9, die bei einem Drehmeißel verwendet wird, gezeigt. Auf dieser Wendeplatte sind Temperatursensoren und eine Verschleißsensoranordnung 11 in Form von Leiterbahnen bzw. Widerstandsschichten direkt auf der Spanfläche mit und ohne Spanführungsnut aufgebracht. Die Temperatursensoren weisen beispielsweise einen mäanderförmigen Abschnitt 12 auf, die mit ihren einen Anschlüssen über Verbindungsleitungen 13 jeweils mit Kontaktflächen 14 verbunden sind und mit ihren anderen Anschlüssen an eine gemeinsame gleichfalls mit einer Kontaktfläche 14 verbundenen Anschlußleitung 15 angeschlossen sind. Die Verschleißsensoranordnung 11 besteht aus einer Anzahl von nebeneinanderliegenden Leiterbahnen 16, die einerseits jeweils an Kontaktflächen 14 liegen und andererseits gleichfalls an die gemeinsame Anschlußleitung 15 angeschlossen sind. Die Kontaktflächen 14 stehen mit einer Verarbeitungsschaltung entsprechend Schaltung 8 in Fig. 1 in Verbindung. Die Kontakte bzw. Kontaktflächen werden aus einem Kontaktmaterial wie Au, Ag, Pt und dergleichen gebildet.

Die Temperatur an dem Ort der Temperatursensoren 10 wird über die Änderung des Widerstands an den mäanderförmigen Abschnitten 12 aufgrund der bei der Bearbeitung auftretenden Erwärmung erfaßt. Der Verschleiß der Wendeschneidplatte 9 an den Schneidkanten wird über die Leiterbahnen 16 festgestellt, deren Widerstandsänderung in geeigneter Weise mit dem Verschleißzustand korreliert wird oder die unterbrochen werden, wenn der Verschleiß mit längerer Bearbeitungsdauer fortschreitend zunimmt. In gleicher Weise kann ein Bruch der Platte festgestellt werden.

Im dargestellten Ausführungsbeispiel könnte beispielsweise die Kontaktierung der Kontaktflächen 14 über eine entsprechende Kontaktflächen aufweisende Befestigungsschraube erfolgen, die mit Leiterbahnen versehen ist, um die Signale weiterzuleiten. Es ist auch denkbar, daß die Verarbeitungsschaltung in der Mitte der Wendeschneidplatte als Mikrochip angeordnet ist und direkt mit den Kontaktflächen verbunden ist. In diesem Fall ist eine Kühlung des Chips unter Anwendung von Kühlkanälen im Chip oder in der Halterung vorgesehen.

Grundsätzlich weist der durch Sputtern aufgebrachte Schichtaufbau des Werkzeugs z.B. der Wendeschneidplatte eine in ein Substrat als Grundkörper implantierte Gradientenschicht auf, bei der Metall kontinuierlich in einen Isolator übergeht, z. B. Ti-TiOx-TiO2, wobei der Sauerstoff kontinuierlich zunehmend zugeführt wird. Unter "implantiert" soll in der vorliegenden Anmeldung verstanden werden, daß die Gradientenschicht in die durch Ionenätzung mit Abtragungen versehene Oberfläche des Substrats bzw. der vorangehenden Schicht mit geringer Tiefe (z.B. 10 nm - 100 nm) eingreift, wobei die Abtragung über die an dem Substrat liegende (negative) Biasspannung z.B. zwischen 70 V und 2000 V und damit durch den Ionenbeschuß gesteuert werden kann. Durch die Maßnahme der "Implantierung" wird die Haftung verbessert.

Die Implantation kann auch dadurch erfolgen, daß eine oder mehrere der Kathoden der Mehrtargetsputteranlage im Arc-Mode (Bogenentladung) betrieben wird und die dabei gebildeten Metallionen bei negativem Substratbias in die Oberfläche der Substrate bzw. der Ausgangsschicht eingebaut werden.

Auf die Gradientenschicht kann im einfachsten Fall eine weitere Gradientenschicht als Sensorschicht aufgebracht werden, z.B. TiO₂-TiOx-Ti unter Verringerung der Sauerstoffzufuhr, wobei anschließend die Sensorschicht entsprechend den Verschleißsensoren und Temperatursensoren strukturiert wird.

Es können jedoch anstelle der letzteren Gradientenschicht zwei aufeinanderfolgend aufgebrachte und über eine dazwischenliegende Ionenätzung implantierte Metallschichten unterschiedlichen Materials aufgebracht werden, wobei die eine Schicht die Widerstandsschicht für die Verschleißsensoren und die andere Schicht eine thermoresistive Schicht für die Temperatursensoren bildet. Dadurch kann die Empfindlichkeit der Sensoren verbessert werden. Die Schichten werden entsprechend strukturiert.

Als weiteres wird eine Verschleißschutzschicht aufgebracht und gegebenenfalls wird vorher eine implantierte Isolationsschicht abgeschieden. Die Verschleißschutzschicht kann als Gradientenschicht, z.B. unter zunehmender Zufuhr von Stickstoff ausgebildet sein. Wenn als Verschleißschutzschicht z.B. hBN-cBN, Al₂O₃ oder Diamant verwendet wird, ist eine Isolationsschicht nicht notwendig.

Alle Schichten werden so hergestellt, daß sie unter gleichzeitigem Ionenbeschuß aufwachsen, der durch die Biasspannung des Substrats gesteuert wird. Die Dichte und Härte der Schichten wird gleichfalls über die Biasspannung bzw. -potential gesteuert, wobei selbstverständlich ein Aufwachsen der Schichten möglich sein muß. Die (negative) Biasspannung liegt zwischen 70 V und 2000 V, wobei für das Aufwachsen der Schichten Werte zwischen 100 V und 400 V und für das Ionenätzen auch höhere Werte gewählt werden. Wenn die unterschiedlichen Schichten nicht kontinuierlich abgeschieden werden, wird jeweils zwischen dem Abscheiden der Schichten eine Ionenätzung für die Haftverbesserung der darauffolgenden Schicht durchgeführt.

Als Materialien für die Isolationsschichten und die Verschleißschutzschichten können TiO₂, BN, Al₂O₃, SiO₂ und dergleichen bzw. TiN, cBN, Al₂O₃, TiC, TiAlN, TiCN, Diamant und dergleichen verwendet werden.

Wenn die Sensorschichten auf eine gekrümmte Fläche aufgebracht werden, z.B. die Spanführungsnut, kann keine Photolithographie für die Strukturierung angewandt werden. Hier wird eine Lithographie mit großer Tiefenwirkung z.B. Röntgenlithographie, Laserstrahllithographie oder die Drei-Lagen-Technik verwendet, bei der eine ebene Fläche durch Auffüllen mit einem Photoresist oder Kunststoff und Aufbringen einer anorganischen Schicht (z.B. Metallschicht) hergestellt wird und die Anordnung anschließend geätzt wird.

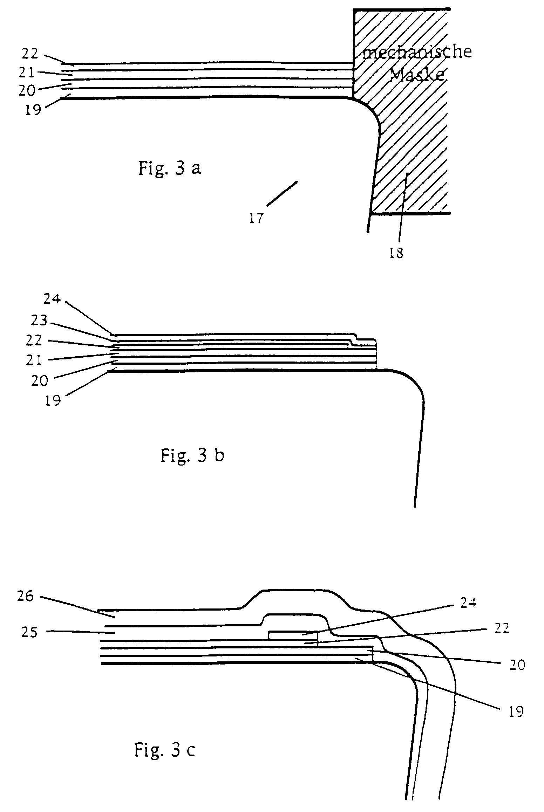

In Fig. 3a bis 3c wird die Herstellung einer Wendeschneidplatte nach einem Ausführungsbeispiel mit integrierten Sensoren näher beschrieben. Als Substrat dient eine handelsübliche Wendeschneidplatte 17 aus einem Hartmetall oder einem Cermet, die eine Dicke im Bereich von 3 bis 5 mm aufweist. Die Wendeschneidplatte 17 weist eine glatte Oberfläche auf. Vor dem Beschichten wird die Wendeschneidplatte mit einem alkalischen Reinigungsbad entfettet und in deionisiertem Wasser gespült und getrocknet und in eine mechanische Maske 18 eingespannt. Die Beschichtung erfolgt in einer bekannten Sputteranlage, wobei der Substrattisch, der die Halterung für eine oder mehrere Wendeschneidplatten aufnimmt, mit einer Biasquelle verbunden ist, wodurch hoch- und mittelfrequente Versorgungsspannungen als auch Gleichstromversorgung an den Substrattisch angelegt werden können. Nach dem Einbau der Substrate wird auf 10⁻⁵ mbar evakuiert, ein Ionenätzschritt zur Vorreinigung der Substrate bei einem negativen Potential an dem Substrathalter von 600 V durchgeführt, wobei gleichzeitig ein Freisputtern der Targets erfolgt. Es wird zunächst eine Ti-TiOₓ-Gradientenschicht zur Verbesserung der Haftung mit einer Dicke von 100 nm als Zwischenschicht 19 aufgebracht, worauf die Abscheidung einer TiO₂-Isolationsschicht 20 folgt. Auf die Isolationsschicht wird eine weitere Zwischenschicht 21 aus Titan abgeschieden. Zwischenschichten 19 und 21 und Isolationsschicht 20 weisen eine Gesamtdicke von 1,5 - 3,0 µm auf. Der Biasspannungsgradient an dem Substrattisch beträgt dabei 1400 V - 100 V.

In einem nächsten Teilprozeß wird zur Herstellung einer Leiterbahnschicht 22 eine Molybdänschicht mit einer Dicke von 1 µm oder eine Titanschicht bei einem Substratbias von -50 V aufgestäubt. Die Ätzung der Leiterbahnen wird unter Anwendung üblicher lithographischer Methoden durchgeführt, wobei die Wendeschneidplatte mit einem Photoresist mit Hilfe eines Spin-Coaters belackt, im UV-Kontaktverfahren mit Hilfe einer Cr-Maske belichtet und in einem alkalischen Entwickler entwickelt wird. Anschließend wird in einer Ätzanlage die Mo-Schicht strukturiert.

Entsprechend Fig. 3b wird anschließend eine thermoresistive Schicht durch Sputtern aufgebracht, die aus einer Gradientenhaftschicht als Zwischenschicht 23 und einer Widerstandsschicht 24 aus Mo besteht, die in einer Dicke von 100 nm aufgesputtert wird. Die thermoresistive Schicht 23, 24 wird wiederum mit den üblichen lithographischen Methoden wie oben strukturiert, so daß die Thermosensoren die gewünschte Form erhalten. Mit Hilfe der Mäandergeometrie und der Bahnbreite wird ein Widerstand von ca. 100 Ω realisiert.

Entsprechend Fig. 3c wird eine weitere Isolationsschicht aus TiO₂ 25 aufgebracht, wobei gleichfalls eine Gradientenhaftschicht vorgesehen wird, die jedoch in Fig. 3c ebenso wie die zweite und dritte Zwischenschicht nicht dargestellt ist. Als letztes wird die Verschleißschutzschicht 26 aus TiN in einer Dicke von 5 µm aufgesputtert.

Diese beschriebene Schichtfolge wird nur als Beispiel angegeben und es können andere Materialien verwendet werden. Beispielsweise kann als Isolationsschicht ein Bornitrid BN verwendet werden und die Verschleißschutzschicht kann gleichfalls als cBN-Schicht ausgebildet sein.

Ein Herstellungsprozeß für ein derartiges Ausführungsbeispiel ist wie folgt. Die Wendeschneidplatte (wie oben) als Substrat wird gereinigt, entfettet und in eine 4-Target-Sputteranlage eingebaut, die auf < 2x10⁻⁵ mbar evakuiert wird. Die Targets und die Substrate werden durch Ionenätzung bei geschlossenem Shutter gereinigt. Anschließend wird eine Gradientenschicht aus TiBN und eine Isolationsschicht aus BN(C) aufgestäubt. Dies wird in einer DC-Magnetron Sputteranlage bei 4x10⁻³ mbar Totaldruck durchgeführt, wobei ein TiB2-Target (Gradientenschicht) und ein B4C-Target (Isolationsschicht) reaktiv mit unterschiedlichen N2/Ar Gasmischungen gesputtert werden. Anschließend wird eine Leiterbahnschicht aus Mo mit einer Schichtdicke von 1 µm hergestellt, die lithographiert und strukturiert wird. Die thermoresistiven Sensorelemente werden durch Sputtern von Mo in einer Schichtdicke von 100 nm, Fotolithographie und Strukturierung durch reaktive Ionenätzung hergestellt. Daraufhin wird eine Gradientenhaftschicht und eine Verschleißschutzschicht durch Sputtern aufgebracht. Hierzu wird das Werkzeug in eine Magnetronsputteranlage eingebaut. Das Target besteht aus B4C. Nach einem Freisputterprozeß für das Target und einem kurzen Ionenätzschritt zur Substratreinigung wird eine Ar/N2 Gasmischung von 30 % N2 in den Rezipienten eingeleitet und bei einem Gasdruck von 50 x 10⁻³ mbar eine nanokristalline c-BN Schicht auf das Werkzeug aufgestäubt. Die Leistung am Target (250 x 120 mm) beträgt 1,5 KW, am Substrat wird eine Gleichspannung von 250 V angelegt. Die Beschichtungstemperatur beträgt ca. 300° C. Unter diesen Bedingungen bildet sich eine harte Verschleißschutzschicht aus, die neben der kubischen BN-Phase nur noch geringe Anteile von hexagonalem BN und ca. 5 % Kohlenstoff vermutlich in karbidischer oder sp3-Bindung enthält. Der Vorteil einer Verschleißschutzschicht aus c-BN oder Diamant besteht mit Blick auf die Integration von Dünnschichtsensoren darin, daß gegenüber den leitfähigen Ti-basierenden Hartschichtsystemen eine Isolationsschicht entfallen kann.

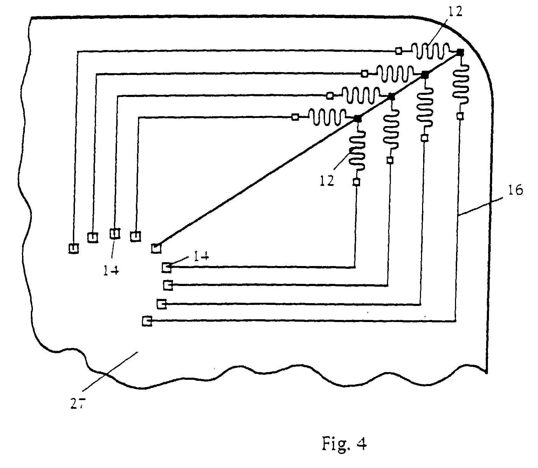

In Fig. 4 ist eine weitere Aufsicht auf eine Wendeschneidplatte 27 dargestellt, bei der eine Kombination von Temperatur- und Verschleißsensoren ("Multifunktionssensor") vorgesehen sind. Bei dieser Ausführungsform sind die mäanderförmigen Abschnitte 12 der Temperatursensoren in die Leiterbahnen 16 der Verschleißsensoranordnung integriert, so daß keine zusätzlichen Leiterbahnen für die Temperatursensoren vorgesehen werden müssen.

Selbstverständlich können weitere Sensoren in die Werkzeugen integriert sein, die direkt als Schicht ausgebildet sind oder an dem Werkzeug z. B. an der Unterseite oder der Halterung vorgesehen werden. So kann beispielsweise ein Kraft- und/oder Biegesensor als piezoelektrische Schicht aufgebracht werden oder als Dehnungsmeßbrücke ausgebildet werden. Auch sind Vibrationssensoren denkbar, so daß eine Vielzahl von Einflußgrößen erfaßt werden können.

## Patentansprüche

1. Werkzeug für Umform- und Zerspanungsvorrichtungen, das in eine Halterung einspannbar ist, und aus einem Substrat mit einer darauf aufgebrachten, mindestens einen Temperatursensor (10) und eine Verschleißsensoranordnung (11), die als strukturierte leitende Metallschicht ausgebildet sind, und eine Verschleißschutzschicht aufweisenden Schichtanordnung besteht, wobei die Sensoren (3, 10, 11) mit einer Verarbeitungsschaltung (8) verbindbar sind, wobei die Sensoren (3, 10, 11) an der direkten Verschleißfläche des Werkzeugs vorgesehen sind,
**dadurch gekennzeichnet,** daß die Schichtanordnung ein geschlossener Schichtaufbau ist, der mindestens eine in die Oberfläche des Substrats implantierte aufgewachsene erste Gradientenschicht, die von einer mit dem Substrat verbundenen Metallschicht kontinuierlich in eine Isolationsschicht übergeht, sowie die mindestens eine leitende, die Sensoren bildende strukturierte Metallschicht und die Verschleißschutzschicht aufweist.

2. Werkzeug nach Anspruch 1, dadurch gekennzeichnet, daß die mindestens eine leitende, die Sensoren (3, 10, 11) bildende strukturierte Metallschicht als zweite Gradientenschicht ausgebildet ist, die kontinuierlich von der Isolationsschicht der ersten Gradientenschicht in eine Metallschicht übergeht.

3. Werkzeug nach Anspruch 1 oder Anspruch 2, dadurch gekennzeichnet, daß zwei jeweils in die davor liegende Schicht implantierte leitende, die Sensoren (3, 10, 11) bildenden strukturierte Metallschichten vorgesehen sind, von denen eine eine Verschleißsensoranordnung bildende Widerstandsschicht und die andere eine Temperatursensoren bildende thermoresistive Schicht ist.

4. Werkzeug nach einem der Ansprüche 1 bis 3, dadurch gekennzeichnet, daß die Verschleißschutzschicht als dritte Gradientenschicht unter Zwischenschaltung einer Isolationsschicht ausgebildet ist.

5. Werkzeug nach einem der Ansprüche 1 bis 4, dadurch gekennzeichnet, daß die erste und zweite Gradientenschicht eine Titan-Titanoxid- und die dritte Gradientenschicht eine Titan-Titannitridschicht sind.

6. Werkzeug nach einem der Ansprüche 1 bis 3, dadurch gekennzeichnet, daß die Verschleißschutzschicht eine in die darunterliegende Schicht implantierte kubische Bornitridschicht oder Diamantschicht ist.

7. Werkzeug nach einem der Ansprüche 1 bis 6, dadurch gekennzeichnet, daß das Substrat eine Wendeschneidplatte (2) aus Hartmetall oder Cermet ist, wobei der Schichtaufbau auf der Spanfläche mit oder ohne Spanführungsnut aufgebracht ist.

8. Werkzeug nach einem der Ansprüche 1 bis 7, dadurch gekennzeichnet, daß die Verarbeitungsschaltung (8) als Mikrochip ausgebildet ist, die an dem Werkzeug oder der Halterung angeordnet ist und mit den Sensoren verbunden ist.

9. Werkzeug nach einem der Ansprüche 1 bis 8, dadurch gekennzeichnet, daß zusätzlich Kraft- und/oder Biegesensoren als ferroelektrische oder piezoresistive Schichten vorgesehen sind.

10. Vorrichtung zur Regelung von Umform- und Zerspanungsprozessen, mit einer Umform- und Zerspanungsvorrichtung, die ein in einer Halterung eingespanntes Werkzeug nach einem der Ansprüche 1 bis 9 aufweist, und mit einer Steuer-Regelschaltung, die über eine mit den Sensoren des Werkzeugs verbundene Verarbeitungsschaltung Temperatur- und Verschleiß- und ggf. Kraftsignale empfängt und abhängig von diesen Signalen die Parameter der Umform- und Zerspanungsvorrichtung wie Geschwindigkeit, Vorschub oder dergleichen steuert bzw. regelt.

11. Verfahren zur Herstellung eines Werkzeugs für Umform- und Zerspanungsvorrichtungen nach einem der Ansprüche 1 bis 9, dadurch gekennzeichnet, daß, das Substrat einer Ionenätzung unterzogen wird und auf die direkte Verschleißfläche kontinuierlich eine Gradientenschicht durch Sputtern bei zunehmender Zufuhr eines Reaktionsgases aufgewachsen wird, die von einer Metallschicht in eine Isolationsschicht übergeht, daß mindestens eine leitende Sensorschicht durch Sputtern aufgebracht und anschließend strukturiert wird und daß eine Verschleißschutzschicht durch Sputtern abgeschieden wird, wobei alle Schichten unter gleichzeitigem gesteuerten Ionenbeschuß aufwachsen.

12. Verfahren nach Anspruch 11, dadurch gekennzeichnet, daß die leitende Sensorschicht als Gradientenschicht mit zunehmender Reduktion des Reaktionsgases aufgebracht wird.

13. Verfahren nach Anspruch 11 oder Anspruch 12, dadurch gekennzeichnet, daß die Verschleißschutzschicht als Gradientenschicht mit Zunahme der Zufuhr eines Reaktionsgases aufgewachsen wird.

14. Verfahren nach einem der Ansprüche 11 bis 13, dadurch gekennzeichnet, daß die Menge der Abtragung von Material vom Substrat während der Ionenätzung und/oder die Dichte und Härte der aufgebrachten Schichten des Schichtaufbaus durch die Biasspannung bzw. Biaspotential am Substrat für den Ionenbeschuß gesteuert wird, wobei Werte zwischen 70 V und 2000 V vorgesehen werden.

15. Verfahren nach einem der Ansprüche 11 bis 14, gekennzeichnet durch folgende Schritte:
a) Vorreinigen eines Substrats durch Ionenätzung,
b) Aufbringen einer als Haftverbesserungsschicht und Isolationsschicht wirkende Gradientenschicht Ti-TiOₓ-TiO₂-Isolationsschicht auf das Substrat durch ein Sputterverfahren und zunehmender Zufuhr von Sauerstoff,
c) Aufbringen einer Ti, Mo oder W enthaltenden Leiterbahnschicht mit dem Sputterverfahren,
d) Aufbringen einer Maske entsprechend den gewünschten Leiterbahnen und Kontaktflächen und Ätzen der nicht durch die Maske abgedeckten Leiterbahnschicht,
e) Aufbringen einer thermoresistiven Schicht aus Mo oder dergleichen durch Sputtern,
f) Strukturieren der thermoresistiven Schicht entsprechend Schritt d),
g) Aufbringen einer zweiten TiO₂-Isolationsschicht entsprechend Schritt b), und
h) Aufbringen einer Verschleißschutzschicht als Gradientenschicht Ti-TiN durch Sputtern und zunehmender Zufuhr von Stickstoff.

16. Verfahren nach einem der Ansprüche 11 bis 14, gekennzeichnet durch folgende Schritte:
a) Vorreinigen eines Substrats durch Ionenätzung,
b) Aufbringen einer Gradientenschicht aus TiBN und einer Isolationsschicht aus BN,
c) Aufbringen einer Ti, Mo oder W enthaltenden Leiterbahnschicht,
d) Strukturieren der Leiterbahnschicht,
e) Sputtern einer thermoresistiven Schicht aus Mo oder dergleichen Materialien,
f) Strukturieren der thermoresistiven Schicht,
g) Aufbringen einer Gradientenhaftschicht und einer Verschleißschutzschicht aus c-BN durch Sputtern.

17. Verfahren nach einem der Ansprüche 11 bis 16, dadurch gekennzeichnet, daß die Substrattemperatur während der Schichtherstellung im Bereich von 50° C bis 900° C liegt.

18. Verfahren nach einem der Ansprüche 11 bis 17, dadurch gekennzeichnet, daß die Leiterbahnen und thermoresistive Schicht zur Stabilisierung getempert werden.

19. Verfahren nach einem der Ansprüche 11 bis 18, dadurch gekennzeichnet, daß zur Strukturierung der Sensorschichten bei gekrümmten Substratflächen eine Lithographie mit großer Tiefenwirkung z.B. Röntgenlithographie, Laserlithographie oder die Drei-Lagen-Technik verwendet wird.

## Claims

1. Tool for forming and cutting apparatuses, which is clampable into a holder and composed of a substrate with a thereonto placed layer arrangement comprising at least one temperature sensor (10) and a wear sensor arrangement (11), which is arranged as a structured conductive metal layer, and comprising a wear protection layer, and the sensors (3, 10, 11) are connectable to a processing circuit (8), and the sensors (3, 10, 11) are provided on the direct wear surface of the tool, **characterised in that** the layer arrangement is a closed layered structure comprising at least one grown gradient layer implanted into the surface of the substrate which merges continuously from a metal layer which is connected to the substrate into an insulation layer, as well as the at least one conducting structured metal layer which form the sensors and the wear protection layer.

2. Tool according to Claim 1, **characterised in that** the at least one conducting structured metal layer which forms the sensors (3, 10, 11) is designed as a second gradient layer which merges continuously from the insulation layer of the first gradient layer into a metal layer.

3. Tool according to Claim 1 or Claim 2, **characterised in that** two respective conducting metal layers, which are implanted in the layer in front thereof and form the sensors (3, 10, 11), are provided, of which one is a resistance layer which forms a wear sensor arrangement and the other is a thermo-resistive layer which forms temperature sensors.

4. Tool according to one of Claims 1 to 3, **characterised in that** the wear protection layer is designed as a third gradient layer with an insulation layer thereinbetween.

5. Tool according to one of Claims 1 to 4, **characterised in that** the first and second gradient layer is a titanium - titanium oxide layer and the third gradient layer is a titanium - titanium nitride layer.

6. Tool according to one of Claims 1 to 3, **characterised in that** the wear protection layer is a cubic boron nitride layer or diamond layer implanted into the layer therebelow.

7. Tool according to one of Claims 1 to 6, **characterised in that** the substrate is a rotary cutting plate (2) of hard metal or cermet, and the layer structure is applied to the cutting surface with or without cutting guide groove.

8. Tool according to one of Claims 1 to 7, **characterised in that** the processing circuit (B) is a microchip arranged on the tool or the holder and connected to the sensors.

9. Tool according to one of Claims 1 to 8, **characterised in that** load and or flexural sensors are additionally provided as ferro-electrical or piezo-resistive layers.

10. Device for regulating forming and cutting processes, comprising a forming and cutting device comprising a tool clamped into a holder according to one of Claims 1 to 9, and with a control regulating circuit which receives via a processing circuit, which is connected to the sensors of the tool, temperature and wear and, if appropriate, load signals and dependent on these signals controls or regulates the parameters of the forming and cutting device, such as speed, feed or the like.

11. Process for the manufacture of a tool for forming and cutting devices according to one of Claims 1 to 9, **characterised in that** the substrate is subjected to ion etching, and onto the direct wear surface is continuously grown a gradient layer by way of sputtering with increasing delivery of a reaction gas which changes from a metal layer into an insulation layer, and at least one conductive sensor layer is applied by sputtering and subsequently structured, and one wear protection layer is separated by sputtering, and all layers grow under simultaneous controlled ion bombardment.

12. Process according to Claim 11, **characterised in that** the conductive sensor layer is applied as a gradient layer with increasing reduction of the reaction gas.

13. Process according to Claim 11 or Claim 12, **characterised in that** the wear protection layer is grown on as a gradient layer with an increase in delivery of a reaction gas.

14. Process according to one of Claims 11 to 13, **characterised in that** the volume of removal of material from the substrate during ion etching and/or the density and hardness of applied layers of the layer structure are controlled by bias voltage or bias potential on the substrate for the ion bombardment, and values between 70 V and 2,000 V are provided.

15. Process according to one of Claims 11 to 14, **characterised by** the following stages:
a) pre-cleaning of a substrate by ion etching;
b) application of a gradient layer Ti-TiOₓ-TiO₂ insulation layer acting as adhesive improvement layer and insulation layer on the substrate by means of a sputtering process and increasing delivery of oxygen;
c) application of a Ti, Mo or W containing conducting path layer by way of the sputtering process;
d) application of a mask to correspond with desired conducting paths and contact surfaces, and etching of the conducting path layer which is not covered by the mask;
e) application of a thermo-resistive layer of Mo or the like by sputtering;
f) structuring the thermo-resistive layer according to step d);
g) application of a second TiO₂-insulating layer according to step b); and
h) application of a wear protection layer as gradient layer Ti-TiN by sputtering and increasing delivery of nitrogen.

16. Process according to one of Claims 11 to 14, **characterised by** the following steps:
a) pre-cleaning of a substrate by ion etching;
b) application of a gradient layer of TiBN and an insulation layer of BN;
c) application of a Ti, Mo or W containing conducting path layer;
d) structuring the conducting path layer;
e) sputtering a thermo-resistive layer of Mo or the like materials;
f) structuring the thermo-resistive layer;
g) application of a gradient adhesive layer and a wear protection layer of C-BN by way of sputtering.

17. Process according to one of Claims 11 to 16, **characterised in that** the substrate temperature during production of a layer lies in the range between 50EC and 900EC.

18. Process according to one of Claims 11 to 17, **characterised in that** the conducting paths and the thermo-resistive layer are tempered for the purpose of stabilisation.

19. Process according to one of Claims 11 to 18, **characterised in that** for structuring the sensor layers with curved substrate surfaces a lithography of greater effective depth is used, for example X-ray lithography, laser lithography or the three-layer technique.

## Revendications

1. Outil pour des dispositifs de formage et de coupe, qui peut être serré dans un dispositif de retenue et est constitué par un substrat comportant un dispositif formé de couches, qui est disposé sur le substrat et comporte au moins un capteur de température (10) et un dispositif formant capteur d'usure (11), qui sont agencés sous la forme d'une couche métallique conductrice structurée, et une couche de protection contre l'usure, dans lequel les capteurs (3,10,11) peuvent être reliés à un circuit de traitement (8), et dans lequel les capteurs (3,10,11) sont prévus sur la surface d'usure directe de l'outil,
caractérisé en ce que le dispositif à couches est une structure à couches fermée, qui comporte au moins une première couche à gradient formée par croissance et implantée dans la surface du substrat et qui forme une transition continue d'une couche métallique reliée au substrat à une couche isolante, ainsi que la au moins une couche métallique conductrice structurée, formant les capteurs, et la couche de protection contre l'usure.

2. Outil selon la revendication 1, caractérisé en ce que la au moins une couche métallique conductrice structurée formant les capteurs (3,10,11) est agencée sous la forme d'une seconde couche à gradient, qui forme une transition continue de la couche isolante de la première couche à gradient à une couche métallique.

3. Outil selon la revendication 1 ou la revendication 2, caractérisé en ce qu'il est prévu deux couches métalliques conductrices structurées, qui sont implantées dans la couche précédente et forment les capteurs (3,10,11) et dont l'une est une couche résistive formant le dispositif formant capteur d'usure et l'autre est une couche thermorésistive formant des capteurs de température.

4. Outil selon l'une des revendications 1 à 3, caractérisé en ce que la couche de protection contre l'usure est agencée sous la forme d'une troisième couche à gradient moyennant l'interposition d'une couche isolante.

5. Outil selon l'une des revendications 1 à 4, caractérisé en ce que les première et seconde couches à gradient sont une couche de titane-oxyde de titane et que la troisième couche à gradient est une couche de titane-nitrure de titane.

6. Outil selon l'une des revendications 1 à 3, caractérisé en ce que la couche de protection contre l'usure est une couche de nitrure de bore ou une couche de diamant, implantée dans la couche sous-jacente.

7. Outil selon l'une des revendications 1 à 6, caractérisé en ce que le substrat est une plaquette de coupe réversible (2) formée d'un métal dur ou d'un cermet, la structure à couches étant disposée sur la surface de formation de copeaux avec ou sans rainure de guidage des copeaux.

8. Outil selon l'une des revendications 1 à 7, caractérisé en ce que le circuit de traitement (8) est agencé sous la forme d'une micro-puce, qui est disposée sur l'outil ou sur le dispositif de retenue et est reliée aux capteurs.

9. Outil selon l'une des revendications 1 à 8, caractérisé en ce qu'en outre des capteurs de force et/ou des capteurs de flexion sont prévus sous la forme de couches ferroélectriques ou piézorésistives.

10. Dispositif pour régler des processus de formage et de coupe, comportant un dispositif de formage et de coupe, qui comporte un outil serré dans un dispositif de retenue, selon l'une des revendications 1 à 9, et comportant un circuit de commande et de régulation, qui reçoit, par l'intermédiaire d'un circuit de traitement relié aux capteurs de l'outil, des signaux de température et d'usure et éventuellement de force et commande ou règle, en fonction de ces signaux, les paramètres du dispositif de formage et de coupe tels que la vitesse, l'avance ou analogue.

11. Procédé pour fabriquer un outil pour des dispositifs de formage et de coupe selon l'une des revendications 1 à 9, caractérisé en ce qu'on soumet le substrat à une corrosion ionique et qu'on fait croître continûment, sur la surface d'usure directe, une couche à gradient au moyen d'une pulvérisation, avec une amenée croissante d'un gaz de réaction, cette couche à gradient réalisant une transition d'une couche métallique en une couche isolante, qu'on dépose par pulvérisation et on structure ensuite au moins une couche conductrice formant capteur et qu'on dépose par pulvérisation une couche de protection contre l'usure, la croissance de toutes les couches s'effectuant au moyen d'un bombardement ionique commandé simultané.

12. Procédé selon la revendication 11, caractérisé en ce que la couche conductrice formant capteur est déposée en tant que couche à gradient avec une réduction de plus en plus importante du gaz de réaction.

13. Procédé selon la revendication 11 ou la revendication 12, caractérisé en ce qu'on fait croître la couche de protection contre l'usure en tant que couche à gradient, en augmentant l'apport d'un gaz de réaction.

14. Procédé selon l'une des revendications 11 à 13, caractérisé en ce que la quantité d'enlèvement de matière du substrat pendant le bombardement ionique et/ou la densité et la dureté des couches déposées de la structure à couches sont commandées par la tension de polarisation ou le potentiel de polarisation appliqué au substrat pour le bombardement ionique, des valeurs entre 70 V et 2000 V étant prévues.

15. Procédé selon l'une des revendications 11 à 14, caractérisé par les étapes suivantes :
a) nettoyage préalable du substrat par corrosion ionique;
b) dépôt d'une couche isolante en Ti-TiOₓ-TiO₂, en tant que couche à gradient agissant en tant que couche améliorant la durée de la couche isolante, sur le substrat au moyen d'un procédé de pulvérisation et d'un apport de plus en plus grand d'oxygène,
c) dépôt d'une couche formant voie conductrice contenant du Ti, du Mo ou du W, au moyen du procédé de pulvérisation,
d) dépôt d'un masque correspondant aux voies conductrices et aux surfaces de contact désirées et corrosion de la couche formant voie conductrice non recouverte par le masque,
e) dépôt d'une couche thermorésistive de Mo ou analogue par pulvérisation,
f) structuration de la couche thermorésistive conformément à l'étape d),
g) dépôt d'une seconde couche isolante de TiO₂ conformément à l'étape b), et
h) dépôt d'une couche de protection contre l'usure en tant que couche à gradient Ti-TiN par pulvérisation et apport de plus en plus grand d'azote.

16. Procédé selon l'une des revendications 11 à 14, caractérisé par les étapes suivantes :
a) nettoyage préalable d'un substrat par corrosion ionique,
b) dépôt d'une couche à gradient formée de TiBN et d'une couche isolante formée de BN,
c) dépôt d'une couche formant voie conductrice contenant du Ti, du Mo ou du W,
d) structuration de la couche formant voie conductrice,
e) dépôt par pulvérisation d'une couche thermorésistive en Mo ou en des matériaux analogues,
f) structuration de la couche thermorésistive,
g) dépôt par pulvérisation d'une couche adhésive à gradient et d'une couche de protection contre l'usure formée de C-BN.

17. Procédé selon l'une des revendications 11 à 16, caractérisé en ce que la température du substrat pendant la fabrication des couches est située dans la gamme allant de 50°C jusqu'à 900°C.

18. Procédé selon l'une des revendications 11 à 17, caractérisé en ce qu'on soumet les voies conductrices et la couche thermorésistive à un recuit pour la stabilisation.

19. Procédé selon l'une des revendications 11 à 18, caractérisé en ce que pour structurer les couches formant capteurs, dans le cas où la surface de substrat est cintrée, on utilise une lithographie avec une action importante en profondeur, par exemple une lithographie aux rayons X, une lithographie à laser ou la technique à trois couches.
